# DEMANDE DE BREVET EUROPEEN

(11) **EP 2 190 275 A1**
(43) Date de publication de la demande: **26.05.2010**
(21) Numéro de dépôt: 09175753.4
(22) Date de dépôt: 12.11.2009
(51) Int. Cl.: H05K 7/14

(54) **Boîtier pour module électronique de contrôle de machine**

(30) Priorité: 20.11.2008 FR 0857883
(71) Demandeur: RADIALL, 93116 Rosny-Sous-Bois Cedex (FR)
(72) Inventeur: Alexandre, Renaud, 37530, MONTREUIL EN TOURAINE (FR); Van der Mee, Marnix, 37270, MONTLOUIS SUR LOIRE (FR); Batteau, Anthony, 37130, LA CHAPELLE AUX NAUX (FR)
(74) Mandataire: Leszczynski, André

(57) **Abrégé**

Boîtier (2) pour module électronique de contrôle de machine (3), notamment de moteur, caractérisé par le fait qu'il comprend :
- une partie inférieure comportant au moins un logement débouchant vers l'extérieur du boîtier pour recevoir au moins un harnais (4) reliant mécaniquement et électriquement le boîtier (2) à la machine et,
- une partie supérieure comportant un fond, deux bords latéraux et un bord transversal définissant un logement pour recevoir le module électronique (3), ladite partie supérieure comportant des moyens de connexion avec des moyens de connexion correspondants du module électronique (3).

## Description

La présente invention a pour objet la fixation d'un module électronique de contrôle sur une machine, notamment sur le carter d'un moteur.

L'invention s'applique plus particulièrement aux moteurs dans le domaine de l'aéronautique.

Il est connu de fixer un module électronique de contrôle directement sur le carter d'un turboréacteur, puis de raccorder ce module électronique à un ou plusieurs harnais par l'intermédiaire de multiples connecteurs circulaires, ce qui peut rendre les opérations de montage et de démontage du module électronique lors de la fabrication du turboréacteur et/ou en vue de sa maintenance relativement coûteuses en temps.

En outre, avec les exemples connus, il est nécessaire d'employer des connecteurs circulaires répartis autour du module de contrôle, ce qui nécessite un grand nombre de connecteurs et qui, du fait de la répétition un grand nombre de fois d'opérations élémentaires, multiplie le risque d'erreurs lors des opérations de raccordement du module électronique au harnais.

On connaît par les demandes EP 0 291 038, EP 0 213 019 et FR 2 881 607 des supports pour recevoir des modules électroniques pour aéronef, ces supports étant fixés par des vis sur une paroi de l'aéronef.

Il existe un besoin pour remédier aux inconvénients précités et l'invention y parvient selon l'un de ses aspects, grâce à un boîtier pour module électronique de contrôle de machine, notamment de moteur, caractérisé par le fait qu'il comprend :
- une partie inférieure comportant au moins un logement débouchant vers l'extérieur du boîtier pour recevoir au moins un harnais reliant mécaniquement et électriquement le boîtier à la machine et,
- une partie supérieure comportant un fond, deux bords latéraux et un bord transversal, définissant un logement pour recevoir le module électronique, ladite partie supérieure comportant des moyens de connexion avec des moyens de connexion correspondants du module électronique.

L'invention a encore pour objet, selon un autre de ses aspects, un boîtier pour module électronique de contrôle de machine, notamment de moteur, relié mécaniquement et électriquement à la machine par au moins un harnais, le boîtier comprenant :
- un fond, deux bords latéraux et un bord transversal définissant un logement pour recevoir le module électronique, et des moyens de connexion avec des moyens de connexion correspondants du module électronique, et
- au moins un plot faisant saillie dans le logement, le plot comportant une partie fixe par rapport au boîtier et une partie mobile par rapport au boîtier, notamment mobile en translation.

L'invention a encore pour objet, selon un autre de ses aspects, un boîtier pour module électronique de contrôle de machine, notamment de moteur, le boîtier comprenant :
- au moins une partie coopérant avec au moins un harnais pour relier mécaniquement et électriquement le boîtier à la machine, et
- un fond, deux bords latéraux et un bord transversal définissant un logement pour recevoir le module électronique, et des moyens de connexion avec des moyens de connexion correspondants du module électronique.

La partie coopérant avec un harnais peut correspondre à une partie inférieure du boîtier. Cette partie inférieure peut comporter au moins un logement pour recevoir l'au moins un harnais, ce logement débouchant par exemple vers l'extérieur.

Le boîtier peut comporter une partie supérieure comportant le fond, les deux bords latéraux et le bord transversal définissant le logement recevant le module électronique, ainsi que les moyens de connexion mentionnés ci-dessus.

Selon l'invention, le module électronique de contrôle moteur n'est pas fixé directement sur le carter du turboréacteur mais est reçu dans le logement ménagé dans la partie supérieure du boîtier, le boîtier intégrant le ou les harnais ainsi que des moyens de connexion et jouant le rôle de station d'accueil du module électronique.

Le terme « boîtier » doit être compris comme synonyme de « station de réception ». Ce boîtier peut avoir toute forme, n'étant pas nécessairement de section de forme rectangulaire, carrée, et peut être au moins en partie ajouré.

Grâce à l'invention, l'installation et la maintenance du module électronique ne nécessitent que son introduction et/ou son extraction du logement ménagé dans la partie supérieure du boîtier.

Les moyens de connexion du boîtier sont avantageusement portés par le bord transversal de la partie supérieure, ce qui permet de réserver la zone inférieure du boîtier à la réception du ou des harnais provenant du moteur.

Le boîtier comporte avantageusement au moins un plot faisant saillie dans le logement depuis le fond de la partie supérieure, ce plot étant avantageusement agencé pour permettre le verrouillage du module électronique dans le logement ménagé dans la partie supérieure du boîtier et la connexion du module électronique au boîtier.

Le boîtier peut être monobloc ou non. Le plot est par exemple assemblé avec la pièce portant le fond et les bords latéraux de la partie supérieure du boîtier.

Par « connexion du module électronique au boîtier », on désigne la position dans le logement ménagé dans la partie supérieure du boîtier du module électronique dans laquelle la zone de connexion du module électronique est accouplée à la zone de connexion du boîtier.

Le plot comporte avantageusement une partie fixe par rapport au boîtier et une partie mobile, notamment selon un axe de translation, par rapport au boîtier, cette partie mobile coulissant par exemple dans la partie fixe lors du déplacement en translation du module électronique dans le logement ménagé dans la partie supérieure du boîtier.

La partie fixe du plot comporte avantageusement un rail de guidage et la partie mobile comporte avantageusement une vis de transmission mobile en rotation et un pavé de transmission mobile en translation. L'utilisateur exerce par exemple un effort sur la vis de transmission pour visser ou dévisser cette dernière, ce qui entraîne un déplacement de la partie mobile du plot dans le logement ménagé dans la partie supérieure du boîtier, cette partie mobile du plot exerçant alors une force sur le module électronique, conduisant à un déplacement de ce dernier dans ledit logement.

L'emploi d'une vis de transmission permet ainsi avantageusement de démultiplier l'effort exercé par l'utilisateur pour déplacer le module électronique dans le logement ménagé dans la partie supérieure du boîtier.

La vis de transmission est par exemple reçue à une de ses extrémités dans un palier immobile en translation et mobile en rotation par rapport au boîtier et à son autre extrémité dans un palier solidaire en translation du pavé de transmission.

La partie mobile du plot comporte avantageusement un contre écrou solidaire de la vis de transmission, permettant par exemple d'exercer l'effort nécessaire à la déconnexion du module électronique du boîtier.

La partie mobile du plot comporte encore avantageusement au moins deux butées à aiguilles, chaque butée étant par exemple placée contre le palier solidaire en translation du pavé de transmission et s'appliquant contre la vis de transmission. De telles butées permettent avantageusement de réduire les efforts de friction entre la vis de transmission, ledit palier et le contre écrou.

Le pavé de transmission comporte avantageusement une face apte à contacter le module électronique comportant une portion inclinée par rapport à l'axe de translation, une telle portion inclinée permettant lors du déplacement du pavé de transmission selon l'axe de translation d'exercer une force sur le module électronique colinéaire à l'axe de translation, visant à la connexion du module électronique au boîtier et une force perpendiculaire à l'axe de translation, visant à verrouiller le module électronique sur le boîtier.

Le pavé de transmission comporte avantageusement un indicateur visuel permettant à un opérateur de détecter que le module électronique est connecté au boîtier, cet indicateur visuel étant par exemple agencé pour être visible par un opérateur tant que le module électronique n'est pas connecté au boîtier.

Le pavé de transmission comporte avantageusement une partie coulissante comportant une paroi montée sur un ou plusieurs ressorts, ces derniers étant par exemple des ressorts à course limitée.

Cette partie coulissante et la portion inclinée décrite ci-dessus définissent par exemple une même face du pavé de transmission, étant par exemple superposées.

Lorsque l'opérateur souhaite extraire le module électronique du logement ménagé dans la partie supérieure du boîtier, les ressorts exercent une force sur la paroi, ce qui peut favoriser le dégagement du module électronique en éloignant le module électronique du pavé de transmission, évitant ainsi le blocage du module électronique par le pavé de transmission.

En outre, les ressorts de la partie coulissante exercent sur le module électronique une force permettant à l'opérateur d'observer l'indicateur visuel porté par le pavé de transmission tant que le module électronique n'est pas connecté au boîtier.

Le tarage des ressorts peut par ailleurs être choisi de façon à correspondre à l'effort de serrage nécessaire pour maintenir le module électronique connecté au boîtier. Grâce à la partie coulissante selon l'invention, la disparition de l'indicateur visuel porté par le pavé de transmission peut ainsi garantir que l'effort de serrage nécessaire a été exercé sur le module électronique.

Le fond de la partie supérieure du boîtier est avantageusement défini par une paroi fixée de façon amovible sur le boîtier, ce qui permet, en démontant cette paroi d'accéder à la partie du ou des harnais engagée dans le ou les logements ménagés dans la partie inférieure du boîtier.

La partie supérieure du boîtier comporte avantageusement un rebord s'étendant en équerre en direction du logement ménagé dans la partie supérieure du boîtier au-dessus du bord transversal, ce qui permet qu'au cours de l'utilisation du turboréacteur, la zone de connexion du boîtier soit protégée par le rebord d'éventuels poussières et ruissellements d'eau, indépendamment de l'inclinaison du boîtier sur le carter.Au moins un des bords latéraux comporte avantageusement un évidement s'étendant sur au moins une partie de la hauteur dudit bord, cet évidement permettant par exemple le passage des mains de l'opérateur lors de l'introduction du module électronique dans le logement ménagé dans la partie supérieure du boîtier, sans risque de blessures.

Au moins un des bords latéraux comporte avantageusement un décrochement s'étendant sur au moins une partie de la largeur dudit bord.

Au moins un indicateur visuel est avantageusement ménagé sur au moins un des bords latéraux, notamment sur le dessus d'au moins un des bords latéraux.

L'invention a encore pour objet, selon un autre de ces aspects, un module électronique de contrôle de machine apte à être reçu dans un boîtier tel que défini précédemment et comportant :
- une zone de réception d'au moins une carte électronique, et
- des moyens de connexion pour coopérer avec les moyens de connexion correspondants du boîtier.

L'invention a encore pour objet, selon un autre de ses aspects, un ensemble comportant un boîtier tel que défini ci-dessus et un module électronique tel que défini ci-dessus.

L'ensemble peut comporter les harnais permettant de relier mécaniquement et électriquement le boîtier à la machine.

Les moyens de connexion du module sont avantageusement portés par une face transversale du module électronique, ce qui permet, contrairement à une implantation centrale de ces moyens de connexion dans le module, de libérer de l'espace pour la ou les cartes électroniques à installer dans le module électronique. Cette face transversale correspond par exemple à la longueur ou à la largeur du module électronique.

Le module électronique comporte avantageusement deux faces latérales, au moins une de ces deux faces latérales définissant des moyens de préhension du module électronique.

Le module électronique comporte avantageusement une cavité destinée à coopérer avec le plot du boîtier défini précédemment pour constituer un système de verrouillage du module électronique au boîtier. Le plot et la cavité définissent avantageusement des moyens de détrompage de l'orientation du module électronique par rapport au boîtier et des moyens de pré-centrage du module électronique dans le logement ménagé dans la partie supérieure du boîtier.

Au moins une des faces latérales du module électronique est définie par une paroi comportant avantageusement un décrochement s'étendant sur au moins une partie de la largeur de ladite paroi. Ce décrochement vient par exemple en butée contre un décrochement d'un bord latéral du boîtier.

Le module électronique comporte avantageusement des moyens rétractables de verrouillage sur le boîtier, par exemple des boulons rétractables portés par le module électronique. Chaque boulon est par exemple associé à un ressort exerçant une force visant à maintenir le boulon en position rétractée lorsque le module électronique n'est pas connecté au boîtier, ce qui permet d'éviter que ces boulons ne fassent saillie sur le boîtier et n'occasionnent des blessures.

Le module électronique comprend une face supérieure comportant avantageusement au moins un indicateur visuel. L'indicateur visuel est avantageusement l'un au moins parmi:
- un indicateur visuel en regard d'une face latérale et associé à la position dans le logement ménagé dans la partie supérieure du boîtier du module électronique dans laquelle le module électronique est connecté au boîtier,
- un indicateur visuel en regard d'une face latérale associé à une position dans ledit logement du module électronique dans laquelle le module électronique est déconnecté du boîtier et,
- un indicateur visuel s'étendant en bordure d'une partie au moins de la face transversale.

La face supérieure du module électronique comporte par exemple les trois indicateurs visuels ci-dessus.

En variante, un indicateur visuel associé à la position dans ledit logement du module électronique dans laquelle le module électronique est déconnecté du boîtier, est disposé en regard de chaque face latérale et un indicateur visuel associé à une position dans ledit logement du module électronique dans laquelle le module électronique est connecté au boîtier est disposé en regard de chaque face latérale, la face supérieure du module électronique comportant ainsi cinq indicateurs visuels.

L'invention permet ainsi à un opérateur de disposer d'un ou plusieurs indicateurs pour déterminer visuellement s'il y a connexion du module électronique au boîtier.

L'invention a encore pour objet, selon un autre de ses aspects, un procédé de fixation d'un module électronique de contrôle sur le carter d'une machine, notamment d'un moteur, caractérisé par le fait qu'il comporte les étapes consistant à:
- relier mécaniquement et électriquement un boîtier tel que défini ci-dessus sur le carter de la machine à l'aide d'au moins un harnais,
- introduire un module électronique à l'intérieur du logement ménagé dans la partie supérieure du boîtier, et
- connecter le module électronique au boîtier.

L'introduction du module électronique à l'intérieur du logement ménagé dans la partie supérieure du boîtier peut comporter les étapes suivantes :
- amener le module électronique en butée contre le fond de la partie supérieure du boîtier et,
- déplacer le module électronique parallèlement aux bords latéraux dudit logement jusqu'à ce que la zone de connexion du module électronique soit accouplée à la zone de connexion du boîtier.

Le procédé peut encore comporter une étape ultérieure consistant à verrouiller le module électronique sur le boîtier grâce à des moyens rétractables de verrouillage du module électronique sur le boîtier.

L'invention permet ainsi de réduire le nombre de manipulations pour fixer le module électronique sur le carter, seules deux opérations de translation étant pour cela nécessaires.

D'autres avantages et caractéristiques de l'invention apparaitront à la lecture de la description qui suit d'un exemple de réalisation non limitatif en se référant au dessin annexé dans lequel :
- la figure 1 est une vue en perspective d'un ensemble comportant un boîtier et un module électronique selon l'invention,
- la figure 2 est une vue en perspective d'un boîtier selon l'invention,
- la figure 3 est une vue en perspective d'un module électronique selon l'invention,
- la figure 4 est une vue en perspective d'un exemple de plot selon l'invention,
- la figure 5 est une vue en coupe selon V-V du plot représenté à la figure 4,
- les figures 6 à 10 représentent différentes étapes lors du verrouillage et de la connexion du module électronique au boîtier,
- la figure 11 représente une étape lors de l'extraction du module électronique du boîtier, et
- la figure 12 est un exemple de mise en oeuvre de l'invention utilisant des connecteurs de coupure.

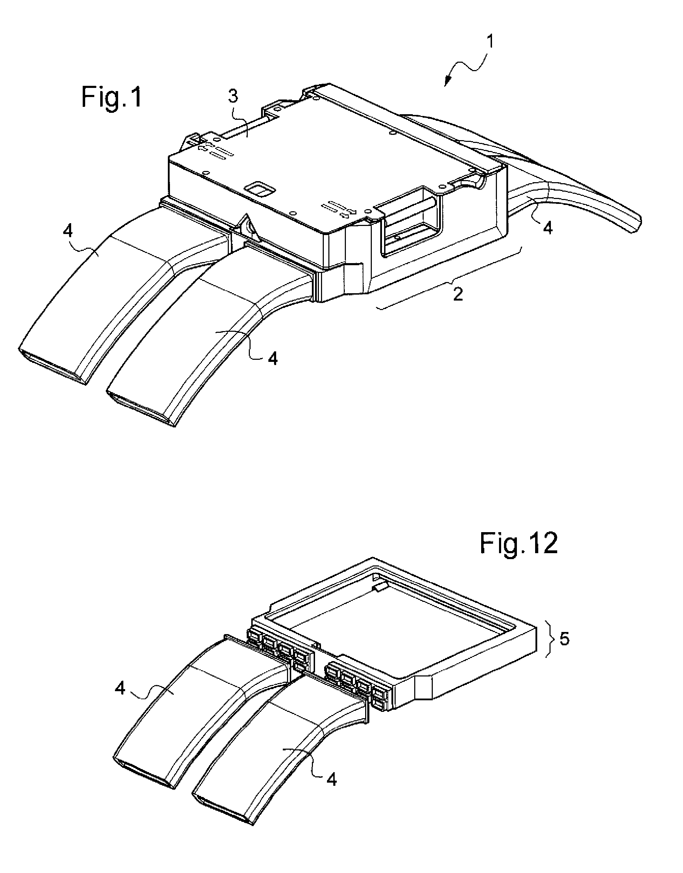

On a représenté à la figure 1 un ensemble selon l'invention désigné globalement par 1.

Cet ensemble 1 comporte un boîtier désigné globalement par 2, recevant un module électronique de contrôle d'un moteur, par exemple d'un turboréacteur, désigné globalement par 3.

Comme on peut le voir, l'ensemble 1 est monté sur le carter du turboréacteur au moyen de quatre harnais 4. Les harnais 4 permettent de relier électriquement l'ensemble 1 au turboréacteur par l'intermédiaire de câbles électriques ou de nappes non représentés.

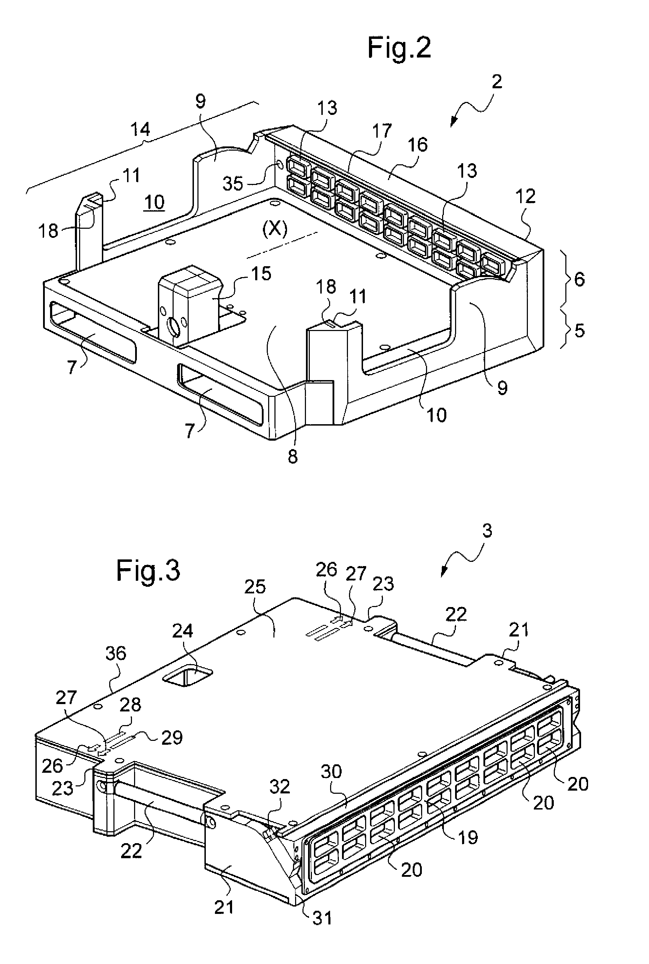

On a représenté à la figure 2 de façon isolée un exemple de boîtier 2. Ce boîtier 2 est par exemple réalisé en alliage d'aluminium.

Comme on peut le voir, le boîtier 2 peut comporter une partie inférieure 5 et une partie supérieure 6. Dans l'exemple décrit, la partie inférieure 5 définit quatre logements 7 pour recevoir chacun un harnais 4.

Dans une variante représentée à la figure 12, les harnais 4 sont reliés au boîtier 2 par l'intermédiaire de connecteurs de coupure, réalisés par exemple en utilisant des connecteurs de type EN4644 ce qui permet avantageusement de retirer le boîtier du carter sans intervenir sur les harnais moteur.

La partie supérieure 6 comporte un fond 8 défini par une paroi montée de façon amovible sur le boîtier, par exemple par l'intermédiaire de vis. Le démontage de cette paroi permet, le cas échéant, d'accéder à la partie des harnais 4 logée dans un des logements 7.

La partie supérieure 6 comprend encore deux bords latéraux 9 qui comportent chacun un évidement 10 s'étendant sur une partie de la hauteur du bord 9. Dans l'exemple décrit, chaque bord latéral 9 comporte également un décrochement 11 s'étendant sur une partie de la largeur du bord 9 et dont le rôle sera précisé plus loin. Les bords latéraux 9 s'étendent selon un axe X selon lequel le module électronique 3 apte à être fixé sur le boîtier 2 peut être translaté par rapport au boîtier, comme on le verra par la suite.

La partie supérieure 6 comprend encore un bord transversal 12 reliant les deux bords latéraux 9 et comportant une pluralité de connecteurs 13, ces derniers définissant une zone de connexion.

Le bord transversal 12 comporte encore deux écrous 35, chaque écrou 35 étant disposé latéralement à la zone de connexion. Chaque écrou 35 s'étend selon un axe oblique par rapport au bord transversal 12.

Dans l'exemple décrit, le fond 8, les bords latéraux 9 et le bord transversal 12 définissent un logement 14 de forme globalement parallélépipédique.

Le boîtier 2 comporte encore un plot 15 faisant saillie dans le logement 14 depuis le fond 8. Le plot est par exemple rapporté sur le reste du boîtier qui peut être monobloc.

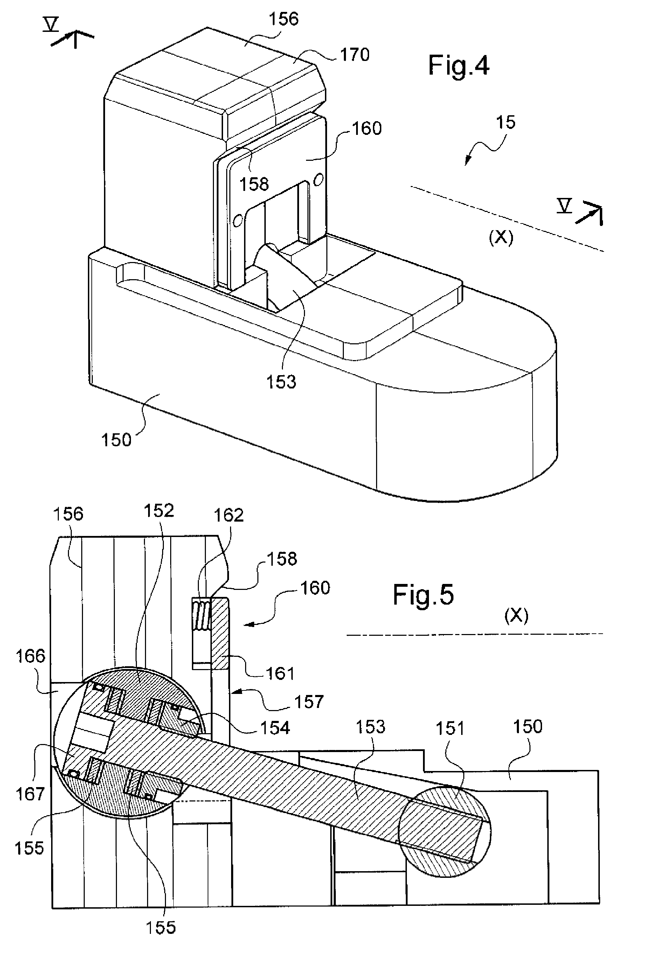

On a représenté à la figure 4 un exemple de plot 15 selon l'invention. Ce plot 15 comporte une partie fixe 150 qui est, dans l'exemple décrit, définie par un rail de guidage se présentant sous la forme de deux demi-coquilles fixées dans la partie inférieure 5 du boîtier 2.

Le plot 15 comporte également une partie mobile qui comprend, comme on peut le voir sur la figure 5, deux paliers cylindriques 151 et 152, une vis de transmission 153, un contre écrou 154 solidaire de la vis de transmission 153, deux butées à aiguilles 155 et un pavé de transmission 156. Une lumière 166 est ménagée dans le pavé de transmission 156 et débouche sur la tête 167 de la vis de transmission 153.

Dans l'exemple décrit, le palier cylindrique 151 est immobile en translation et mobile en rotation par rapport au boîtier 2 et comporte un taraudage pour recevoir la vis de transmission 153 lors de son déplacement.

Le palier cylindrique 152 est reçu dans le pavé de transmission 156 et il est mobile en rotation et en translation par rapport au boîtier 2.

Les butées à aiguille 155 sont disposées contre la vis de transmission 153, de par et d'autre du palier 152.

Le contre écrou 154 est, comme on peut le voir sur la figure 5, solidaire de la vis de transmission 153.

Le pavé de transmission 156 est par exemple réalisé à l'aide de deux demi-coquilles et présente une face 157 apte à venir au contact du module électronique 3 lorsque ce dernier est reçu dans le logement 14 comportant une portion inclinée 158 par rapport à l'axe X et une partie coulissante 160.

Comme représenté sur la figure 5, la partie coulissante 160 comporte une paroi 161 contre laquelle des ressorts 162 exercent une force. Les ressorts 162 sont par exemple des ressorts à course limitée.

Le plot 15 comporte encore un indicateur visuel 170, par exemple sous forme de marquage de couleur, visible sur la figure 4.

Comme on peut le voir sur la figure 2, le bord transversal 12 est surmonté d'un rebord en équerre 16 s'étendant vers le logement 14. Dans l'exemple décrit, une rainure longitudinale 17 est ménagée sur toute la longueur du bord transversal.

Un indicateur visuel 18 est ménagé sur le dessus de chaque bord latéral 9. Cet indicateur visuel est par exemple réalisé en ménageant une encoche sur le dessus de chaque bord latéral. En variante, une pastille colorée est collée ou peinte sur le dessus de chaque bord latéral 9 pour réaliser l'indicateur visuel.

On va maintenant décrire en référence à la figure 3 un exemple de module électronique 3 selon l'invention.

Comme on peut le voir, ce module électronique 3 est de forme globalement parallélépipédique. Le module électronique 3 comporte intérieurement une zone de réception non visible sur la figure pour recevoir une pluralité de cartes électroniques.

Le module électronique 3 présente une face transversale 19 comportant une pluralité de connecteurs 20 définissant une zone de connexion, ces connecteurs étant agencés pour s'accoupler avec les connecteurs 13 du boîtier.

Dans l'exemple décrit, les connecteurs 13 du boîtier 2 sont des connecteurs mâles et les connecteurs 20 du module électronique 3 sont des connecteurs femelles, mais on ne sort pas du cadre de la présente invention lorsque les connecteurs mâles sont portés par le module électronique 3 et les connecteurs femelles sont portés par le boîtier 2.

Le module électronique 3 boîtier présente deux faces latérales 21 comportant chacune une tige 22 s'étendant sur une partie de la longueur d'une face 21, cette tige 22 constituant avantageusement un moyen de préhension du module électronique 3.

Comme on peut le voir sur la figure 3, les faces latérales 21 sont chacune définies par une paroi comportant un décrochement 23 s'étendant sur une partie de la largeur de ladite paroi et dont le rôle sera précisé par la suite.

Dans l'exemple décrit, une cavité traversante 24 est ménagée sur toute la hauteur du module électronique 3.

Le module électronique 3 présente encore une face supérieure 25 sur laquelle débouche la cavité traversante 24 et qui comporte des indicateurs visuels 26 et 27 ménagés en regard de chaque face latérale 21. Chaque indicateur visuel 26 est associé à une zone de texte 28 dans laquelle figure la mention « *disconnected* » et chaque indicateur visuel 27 est associé à une zone de texte 29 dans laquelle figure la mention « *connected* ».

L'invention n'est pas limitée à la présence d'un indicateur visuel 26 et 27 en regard de chaque face latérale 21. En variante, la face supérieure 25 pourrait ne comporter qu'un seul indicateur visuel 26 et qu'un seul indicateur visuel 27.

Dans l'exemple décrit, la face supérieure 25 comporte encore un indicateur visuel 30 s'étendant sur toute la longueur de la face supérieure 25 en bordure de la face transversale 19. Cet indicateur visuel 30 est par exemple réalisé à l'aide d'une bande colorée collée ou peinte sur la face supérieure 25.

La face supérieure 25 et, le cas échéant, la face inférieure du module électronique 3 sont par exemple définies par des parois démontables pour pouvoir accéder aux cartes électroniques logées à l'intérieur du module électronique 3.

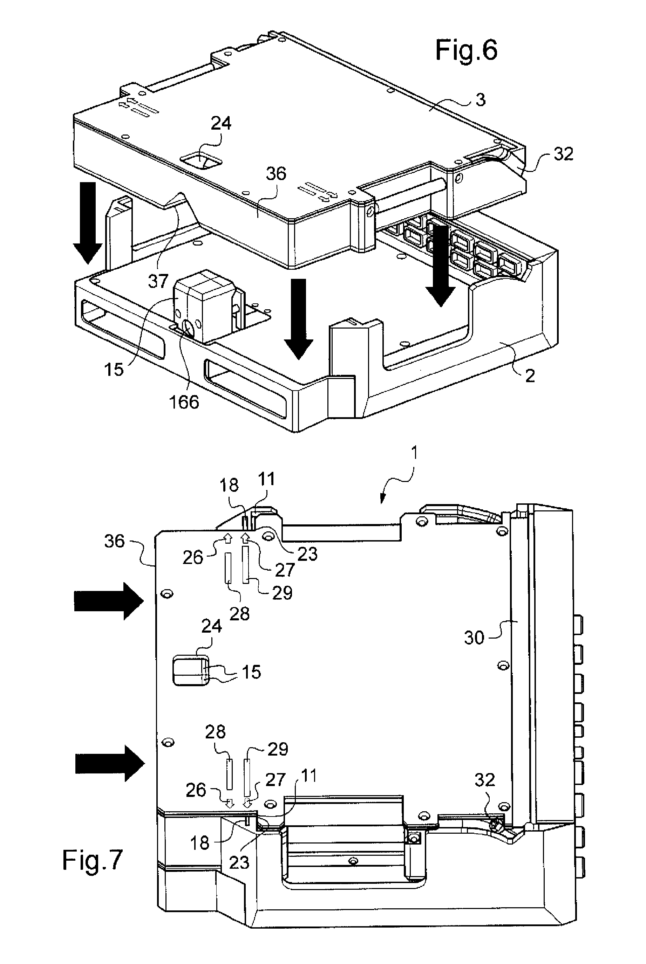

Le module électronique comporte également, comme on peut le voir à la figure 6, une face arrière 36 opposée à la face transversale 19 définissant la zone de connexion. Une lumière 37 est dans l'exemple décrit ménagée dans la partie médiane de cette face arrière 36, sur moins de la hauteur de la face arrière 36. La lumière 37 communique par exemple avec la cavité traversante 24.

Le module électronique 3 comporte encore à une extrémité 31 de chaque face latérale 21 un moyen de verrouillage rétractable 32 sur le boîtier 2, dans l'exemple décrit un boulon rétractable, associé à un ressort 33.

On va maintenant décrire un exemple de fixation d'un ensemble 1 selon l'invention sur le carter d'un turboréacteur.

Le boîtier 2 est d'abord fixé à demeure sur le carter du turboréacteur et relié mécaniquement et électriquement au carter par l'intermédiaire des harnais 4 qui sont introduits dans les logements 7. Lors de cette étape, les câbles électriques du harnais sont reliés à la zone de connexion du boîtier. En variante, la fixation du boîtier 2 sur le carter est effectuée à l'aide des connecteurs de coupure précédemment décrits.

Comme représenté à la figure 6, le module électronique 3 est d'abord déplacé selon un mouvement de translation perpendiculaire au fond 8 de la partie supérieure 6 du boîtier 2, jusqu'à ce que le module électronique 3 vienne en butée contre ce fond 8. Lors de ce mouvement de translation, le plot 15 pénètre à l'intérieur de la cavité traversante 24, ce qui permet de constituer des moyens de détrompage de l'orientation du module électronique 3 par rapport au boîtier 2 et d'assurer un pré-centrage du module électronique 3 dans le logement 14.

A l'issue de cette étape, comme représenté à la figure 7, les décrochements correspondants 23 et 11 du module électronique 3 et du boîtier 2 viennent en regard, de façon à constituer une butée pour le mouvement du module électronique 3 dans le logement 14, empêchant par exemple que le module électronique ne s'échappe du logement 14 lorsque le boîtier est incliné.

Lors d'une étape suivante, le module électronique 3 est déplacé en translation par l'utilisateur selon l'axe X, c'est-à-dire parallèlement aux bords latéraux 9 de la partie supérieure 6 du boîtier 2 qui constituent avantageusement des moyens de guidage du module électronique 3.

Pour connecter le module électronique 3 au boîtier 2, l'utilisateur exerce un effort de vissage sur la vis de transmission 153 à travers la lumière 37 ménagée dans le module électronique 3 et la lumière 166 ménagée dans le pavé de transmission 156, ce qui déplace le pavé de transmission 156 en translation et provoque l'apparition d'une force parallèle à l'axe X exercée par le pavé 156 sur le module électronique 3.

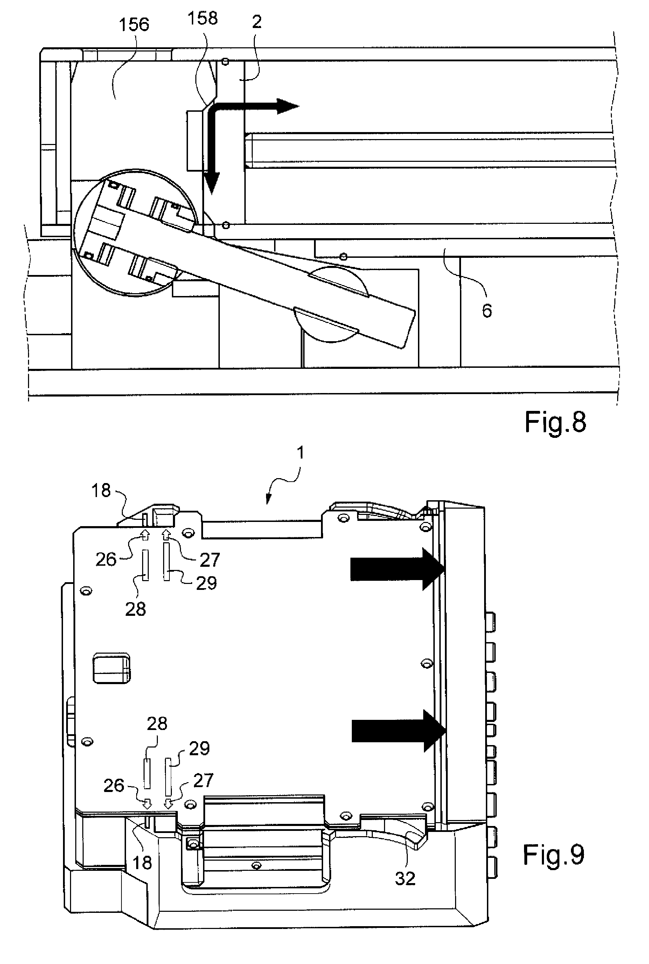

On a représenté à la figure 8 plus en détail l'interaction entre le plot 15 et le module électronique 3 lorsque ce dernier est déplacé en translation dans le logement 14.

Lors du vissage de la vis de transmission 153 par l'utilisateur, les extrémités de cette vis reçues dans le palier 151 et dans le palier 152 sont déplacées en translation.

La présence des butées à aiguilles 155 permet de limiter les phénomènes de friction entre la vis de transmission 153, le palier 152 et le contre écrou 154.

La translation du palier 152 conduit à la translation du pavé de transmission 156 dans le logement 14, le pavé de transmission 156 exerçant alors via la portion inclinée 158 un effort sur les parois de la cavité traversante 24 ménagée dans le module électronique 3.

Comme on peut le voir sur la figure 8, la force exercée par la portion inclinée peut être décomposée en deux forces : une force colinéaire à l'axe X qui provoque le déplacement du module électronique 3 vers la zone de connexion 13 du boîtier 2 et une force perpendiculaire à l'axe X qui assure un verrouillage du module électronique 3 sur le boîtier 2.

Le mouvement de translation est poursuivi jusqu'à ce que la face transversale 19 du module électronique 3 repose contre le bord transversal 12 du boîtier 2, comme représenté à la figure 9, de façon à ce que les connecteurs 13 du boîtier 2 soient accouplés aux connecteurs 20 du module électronique 3.

Les indicateurs visuels 26, 27 et 30 du module électronique 3 sont agencés de telle sorte que dans une position dans le logement 14 du module électronique 3 où le module électronique 3 n'est pas connecté au boîtier 2, tel que représenté à la figure 7, l'indicateur visuel 30 soit visible par l'opérateur et que l'indicateur visuel 18 ménagé sur le dessus de chaque bord latéral 9 du boîtier 2 soit en regard de l'indicateur visuel 26 du module électronique 3 associé à la mention « *disconnected* ».

Dans la position dans le logement 14 du module électronique 3 où le module électronique 3 est connecté au boîtier 2, tel que représenté à la figure 9, l'indicateur visuel 30 n'est plus visible et l'indicateur visuel 18 est en regard de l'indicateur visuel 26 associé à la mention « *connected* ».

En outre, dans la position dans le logement 14 du module électronique 3 représentée à la figure 9, l'indicateur visuel 170 ménagé sur le plot 150 n'est plus visible, alors qu'il est visible dans la position dans le logement 14 du module électronique 3 représentée à la figure 7.

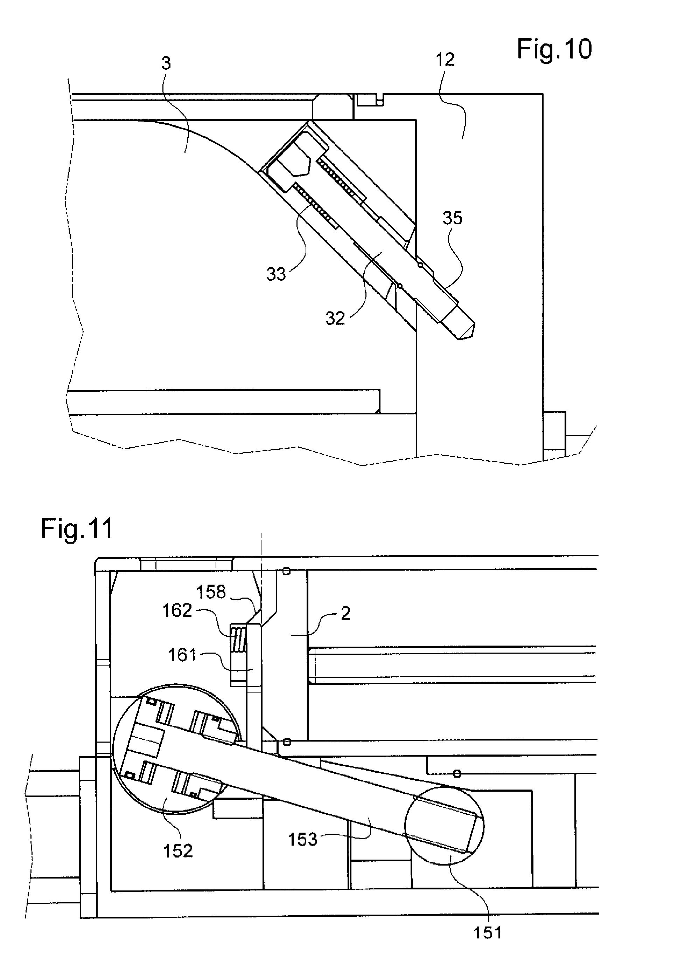

A l'issue de cette étape, l'opérateur peut, comme représenté à la figure 10, achever de verrouiller le module électronique 3 sur le boîtier 2 à l'aide des boulons rétractables 32. Les boulons 32 sont reçus dans les écrous 35 disposés de par et d'autre de la zone de connexion 13.

L'invention peut également permettre de faciliter les opérations d'extraction du module électronique 3.

Ainsi, lors de la déconnexion du module électronique 3 et du boîtier, l'opérateur peut dévisser la vis de transmission 153, ce qui provoque le déplacement de la partie mobile du plot 15 et, similairement à ce qui a été décrit ci-dessus, la création d'une force exercée par la partie mobile du plot sur le module électronique 3 pour son déplacement.

En outre, lorsque le module électronique 3 a été déconnecté du boîtier 2 et se retrouve dans le logement 14 dans une position analogue à celle représentée à la figure 7, le module électronique 3 pourrait, du fait de l'inclinaison potentielle du boîtier 2 et du poids du module électronique 3, être en appui contre le pavé de transmission 156, ce qui rendrait plus difficile l'extraction du module électronique 3 du logement 14.

Comme représenté à la figure 11, grâce à l'invention, les ressorts 162 de la partie coulissante 160 exercent sur le module électronique 3 une force éloignant ce dernier du pavé de transmission 156.L'invention n'est pas limitée à un module électronique de forme globalement parallélépipédique.

L'invention n'est pas limitée au contrôle de moteurs mais pourrait encore être utilisée pour toute autre fonction de gestion ou de racks d'équipements électroniques.

## Revendications

1. Boîtier (2) pour module électronique de contrôle de machine (3), notamment de moteur, **caractérisé par le fait qu'**il comprend :
- une partie (5) coopérant avec au moins un harnais (4) pour relier mécaniquement et électriquement le boîtier (2) à la machine et,
- un fond (8), deux bords latéraux (9) et un bord transversal (12) définissant un logement (14) pour recevoir le module électronique (3), et des moyens de connexion (13) avec des moyens de connexion correspondants (20) du module électronique (3).

2. Boîtier selon la revendication 1, **caractérisé par le fait que** la partie (5) coopérant avec le harnais (4) définit une partie inférieure du boîtier comportant au moins un logement (7) débouchant vers l'extérieur et configuré pour recevoir l'au moins un harnais (4) et **par le fait que** le fond (8), les deux bords latéraux (9) et le bord transversal (12) définissant le logement (14) recevant le module électronique, ainsi que les moyens de connexion (13) correspondent à une partie supérieure (6) du boîtier.

3. Boîtier selon la revendication 1 ou la revendication 2, **caractérisé par le fait qu'**il comporte au moins un plot (15) faisant saillie dans le logement (14) ménagé dans la partie supérieure (6) du boîtier (2) depuis le fond (8) de la partie supérieure (6), le plot (15) comportant une partie fixe (150) par rapport au boîtier et une partie mobile (151, 152, 153, 154, 155, 156) selon un axe de translation (X) par rapport au boîtier (2).

4. Boîtier selon la revendication 3, **caractérisé par le fait que** la partie mobile du plot (15) comporte une vis de transmission (153) mobile en rotation et un pavé de transmission (156) mobile en translation et **par le fait que** la vis de transmission (153) est reçue à une de ses extrémités dans un palier (151) immobile en translation et mobile en rotation par rapport au boîtier (2) et à son autre extrémité dans un palier (152) solidaire en translation du pavé de transmission (156).

5. Boîtier selon la revendication 4 **caractérisé par le fait que** le pavé de transmission (156) comporte une face apte à contacter le module électronique (3) comportant une portion inclinée (158) par rapport à l'axe de translation (X) et **par le fait que** le pavé de transmission (156) comporte une partie coulissante (160) comportant une paroi (161) montée sur au moins un ressort (162).

6. Boîtier selon l'une quelconque des revendications 1 à 5, **caractérisé par le fait que** la partie supérieure (6) comporte un rebord (16) s'étendant en équerre en direction du logement (14) ménagé dans la partie supérieure (6) du boîtier (2), au dessus du bord transversal (12).

7. Boîtier selon l'une quelconque des revendications 1 à 6, **caractérisé par le fait qu'**au moins un des bords latéraux (9) comporte un évidement (10) s'étendant sur au moins une partie de la hauteur dudit bord (9) et **par le fait qu'**au moins un des bords latéraux (9) comporte un décrochement (11) s'étendant sur au moins une partie de la largeur dudit bord (9).

8. Boîtier selon l'une quelconque des revendications 1 à 7, **caractérisé par le fait qu'**au moins un indicateur visuel (18) est ménagé sur au moins un des bords latéraux (3).

9. Ensemble (1) comportant :
- un boîtier (3) selon l'une quelconque des revendications 1 à 8 et,
- un module électronique de contrôle (3) apte à être reçu dans ledit boîtier (2) et comportant :
- une zone de réception d'au moins une carte électronique et,
- des moyens de connexion (20) pour coopérer avec les moyens de connexion correspondants (13) du boîtier (2).

10. Ensemble selon la revendication 9, **caractérisé par le fait que** les moyens de connexion (13) du boîtier sont portés par le bord transversal (12) du boîtier (2) et **par le fait que** les moyens de connexion (20) du module sont portés par une face transversale (13) du module électronique (3).

11. Ensemble selon la revendication 9 ou la revendication 10, **caractérisé par le fait que** le module comporte deux faces latérales (21), au moins une de ces faces latérales définissant des moyens de préhension (22) du module.

12. Ensemble selon l'une quelconque des revendications 9 à 11, **caractérisé par le fait que** le module comporte une cavité destinée (24) à coopérer avec le plot (15) d'un boîtier (2) selon la revendication 3 ou 4.

13. Ensemble selon l'une quelconque des revendications 9 à 12, **caractérisé par le fait qu'**au moins une des faces latérales (21) du module est définie par une paroi comportant un décrochement (23) s'étendant sur au moins une partie de la largeur de ladite paroi.

14. Ensemble selon l'une quelconque des revendications 9 à 13, **caractérisé par le fait que** le module comporte des moyens (32) de fixation rétractable sur le boîtier.

15. Ensemble selon l'une quelconque des revendications 9 à 14, **caractérisé par le fait que** le module comprend une face supérieure (25) comportant l'un au moins parmi :
- un indicateur visuel (26) associé à la position dans le logement (14) ménagé dans la partie supérieure (6) du boîtier (2) du module électronique (3) dans laquelle le module électronique (3) est connecté au boîtier (2),
- un indicateur visuel (27) associé à une position dans ledit logement (14) du module électronique (3) dans laquelle le module électronique (3) est déconnecté du boîtier (2) et
- un indicateur visuel (30) s'étendant en bordure d'une partie au moins de la face transversale (13).
